Europäisches Patentamt

European Patent Office

Office européen des brevets

(19) ◉

(11) Publication number: **0 072 644**
**B1**

(12) **EUROPEAN PATENT SPECIFICATION**

(45) Date of publication of patent specification: 26.03.86

(51) Int. Cl.⁴: **H 01 L 23/56**

(21) Application number: 82304063.9

(22) Date of filing: 02.08.82

(54) Semiconductor chip carrier.

(30) Priority: 14.08.81 US 293052
26.10.81 US 314921

(43) Date of publication of application:
23.02.83 Bulletin 83/08

(45) Publication of the grant of the patent:
26.03.86 Bulletin 86/13

(84) Designated Contracting States:
BE DE FR GB IT NL

(56) References cited:
EP-A-0 018 174
WO-A-81/00949
US-A-4 129 243

IBM TECHNICAL DISCLOSURE BULLETIN, vol.
24, no. 1A, June 1981, pages 46-48, New York,
USA J.R. CAVALIERE et al.: "High-performance
single-chip module"

IBM TECHNICAL DISCLOSURE BULLETIN, vol.
21, no. 5, October 1978, pages 1895-1897, New
York, USA S. MAGDO: "Low inductance
module"

(73) Proprietor: AMP INCORPORATED
P.O. Box 3608 449 Eisenhower Boulevard
Harrisburg Pennsylvania 17105 (US)

(72) Inventor: Grabbe, Dimitry G.
301 Main Street
Lisbon Falls Maine, 04252 (US)

(74) Representative: Gray, Robin Oliver et al
BARON & WARREN 18 South End Kensington
London W8 5BU (GB)

Courier Press, Leamington Spa, England.

## Description

This invention relates to substrates for semiconductor chips, and preferably to a power and ground bus structure where individual resistors between signal leads and the ground bus are selectively connected and resistance values varied.

Chip carriers for integrated circuit semiconductor chips are well known in the art and are widely used. A common type of semiconductor chip carrier comprises a substrate and an array of conductive leads thereon which extend from plural locations at the edges of said substrate toward the center thereof. See, for example, U.S. Patent No. 4,195,193. The leads are connected to bonding pads on semiconductor chips bonded to the center of the chip carrier.

Since leads on the substrate are thin and easily overloaded, it has been necessary to use a plurality of leads on the chip carrier to provide power and ground voltages to appropriate pads on the chip. Many leads in parallel have been used to minimize lead resistance, thus limiting the number of leads which may be utilized as signal leads.

Signal leads on prior art substrates are made up of two parts. The first part is a conductor strip which is deposited on the substrate and extends from the outer edge of the substrate to the inner edge where the chip is attached. The second part is a fine wire or lead, referred to as an elevated lead, which is extended in air from the inner edge of the laminated strip to the chip. A resistor to ground, referred to as a terminating lead resistor, is generally connected to the signal lead beyond the outer edge of the substrate on the printed circuit board. This arrangement results in an unterminated transmission line with a discontinuity in the impedance at the point where the resistor lead is attached. The remaining connection from this point on is referred to as unterminated stub.

The trend in modern integrated circuit technology is toward high frequency signal transmissions. Thus, the high frequency signals on the unterminated signal lead will cause signal reflections at the point of the impedance discontinuity described above.

Generally, when a reference plane in a transmission line is interrupted and the resultant gap is less than one-quarter wavelength, the signals on the transmission line are not seriously disturbed. If, however, the gap is greater than one-quarter wavelength, a larger reflection occurs. Industrial standard is to limit a gap to 1/20 of the wavelength; for military 1/50 is specified. Furthermore, at the low pico-second rise times, the equivalent 1/50 wavelengths are of dimensions encountered in chip packaging. Thus, it is necessary to artificially create reference ground planes to reduce such reflections. The signal reflections could result in undesired switching of adjacent digital circuit components; hence, it is desirable to eliminate the discontinuity in the signal lead. The ideal solution is to move the terminating lead resistor located on the printed circuit board to the point of injection of the signal onto the semiconductor device.

According to the invention a semiconductor chip carrier of the type comprising a substrate and an array of conductive leads formed on a surface thereof, the leads extending from plural locations at the edges of said substrate toward the centre thereof, is characterised in that said carrier further comprises a first reference voltage bus formed on the surface of said substrate and substantially surrounding the center of said substrate, the conductive leads extending on said surface outwardly of said first reference voltage bus which is connected to one of said conductive leads.

The first reference voltage bus is preferably a ground bus and substantially surrounds a second reference voltage bus which is preferably a power bus which surrounds the center of the substrate. By using a copper lead frame which is bonded to the substrate, it is possible to form the bus structure on a substrate with the chip mounted in the center, allowing multiple power and ground connections to be bonded directly between the chip and the bus structure. Only one lead is required for each bus, which permits a decoupling capacitor to be installed across these leads in close proximity to the chip to assure low reactance due to switching.

W.O.81/00949 discloses a chip carrier comprising multiple substrates mounted in a sandwich or stack, each substrate carrying respective circuitry on a surface thereof, one of the substrates carrying a first reference voltage bus substantially surrounding a center thereof and connected by a surface lead extending from an edge portion of the substrate, and a further, intermediate substrate comprises an array of conductive leads formed on a surface thereof and extending from plural locations at edges of said substrate towards the center thereof. In this arrangement circuitry of the different layer is connected by leads extending transversely of the substrates at edges thereof.

According to an embodiment of the present invention, the chip carrier is further characterised in that the conductive leads are mostly signal leads, the substrate having an elongate zone of selectively removable resistive material bonded thereon between a plurality of the signal leads and the reference voltage bus, whereby the resistive material may be selectively removed to form discrete paths of desired resistance between at least one signal lead and the reference voltage bus.

This aspect of the present invention involves a technique which enables signal leads to be terminated through a unique resistor to ground at the point where the deposited signal lead changes to the elevated lead going to the chip. Thus, the impedance discontinuity of the unterminated stub will be eliminated and subsequently reflected high frequency signals will be greatly diminished.

The technique consists of two steps. The first step is to terminate all the signal leads to one side of a resistor zone which is terminated to ground bus on its other side. The next step is to use a laser or some such method beam to dissect the resistor zone into individual resistors, one resistor for each signal lead. The value of each resistor will then be adjusted or trimmed to the required value. This will enable each lead to be terminated to ground through a unique resistor. In the case of completely isolating the signal from the resistive material, the material left between the laser cut and the ground bus will be at ground potential and thereby acts as a reference ground plane. This minimizes the distance over which the elevated lead is not referenced to ground, thus reducing the discontinuity and reflectance of high frequency signal.

An embodiment of the invention will now be described by way of example with reference to the accompanying drawings, in which:—

Figure 1 is a plane view of a substrate having power buses thereon and resistor zones between signal leads and the ground bus;

Figure 2 is an enlarged view of a portion of the substrate between the signal leads and the chip after laser trimming; and

Figure 3 is a side sectional view of a portion of the substrate between the signal leads and the chip.

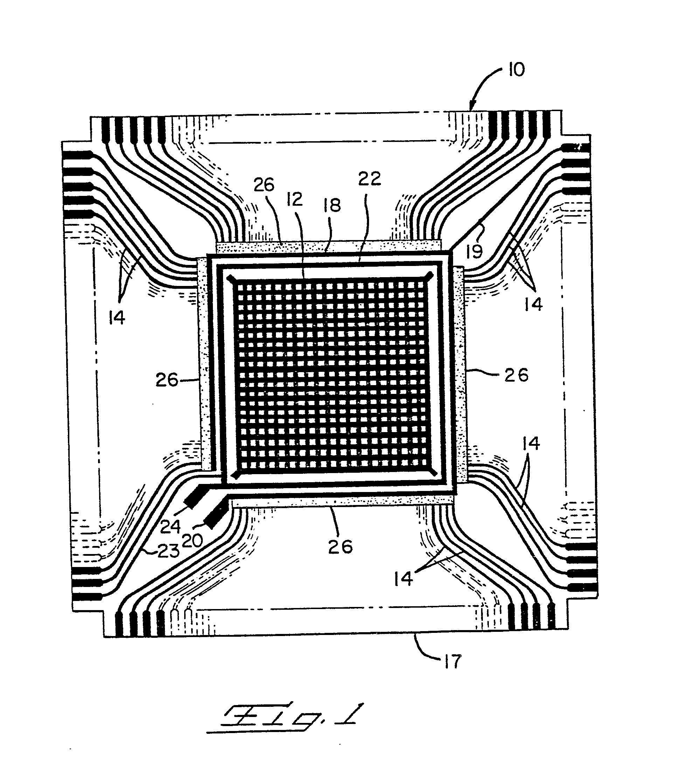

Figure 1 shows the substrate 10 of the present invention prior to placement and connection of a semiconductor chip thereon. The substrate is formed of appropriate dielectric material such as beryllium oxide, aluminum oxide, or other suitable dielectric. The circuitry is formed thereon by a standard process such as photoetching, printing, or a copper lead frame is bonded to the substrate by the procedure described in U.S. Patent Nos. 3,744,120; 3,766,634; 3,911,553; 3,994,430; and 4,129,243. According to the procedure set forth in these patents, the lead frame is oxidized on one side initially and is positioned on the ceramic substrate 10. The lead frame and substrate are then heated to about 1068°C, at which temperature the copper oxide melts and fuses with the substrate. This is below the melting point of the copper. The chip support pad 12, which comprises an electrically and thermally conductive pad for receiving a semiconductor chip thereon, occupies the center of the substrate 10 and is surrounded completely by the power bus 22 which is connected to one corner of the substrate by the power lead 23. The power bus 22 is surrounded almost completely by the ground bus 18 which is connected to the opposite corner by the ground lead 19. The ground bus 18 is broken where the power lead 23 passes through, at which point the mounting pad 20 on the ground bus 18 lies adjacent the pad 24 on the power bus. The pads 20, 24 serve as mounting means for the attachment of a decoupling capacitor between the power and ground structures. A plurality of signal leads 14 extend between each outer edge 17 of the substrate 10 and the ground bus 18, being separated therefrom by four elongate resistor zones 26 formed on the substrate. Thus, the signal leads 14 are connected to the ground bus 18 through the resistor zones 26.

The deposited resistor zones 26 are formed from material of the thick or thin film type which is frequently a composition of carbon with two metal oxides and a binder. The resistor zones can be screen printed and fixed onto the substrate by conventional thick film techniques as is well known in the hybrid circuit art.

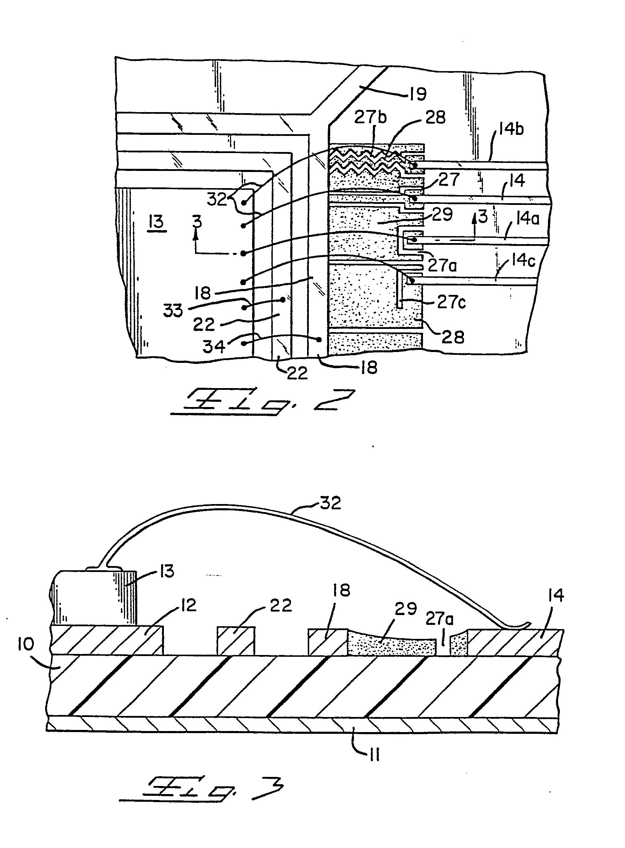

Figure 2 shows the function of the resistor zones 26 with several examples. In general laser cuts 27 are formed in a resistor zone 26 to isolate discrete portions of the resistor zone between each signal lead 14 and the ground bus 18. A laser cut 27a may completely cut off the signal lead 14a from the ground bus 18, leaving a ground plane 29, as shown in section in Figure 3. A defined resistor 28 may be extended between the signal lead 14b and the ground bus 18, by using a zigzag laser cut 27b. Finally, a trimming laser cut 27c may be used to slightly alter the value of the resistance from signal lead 14c to ground 18. Various leads 32, 33, 34 are shown connected to the semiconductor chip 13. Lead 32 connects a signal lead 14 to the chip 13, while lead 33 is a power lead which provides power directly to the chip 13 and lead 34 is a ground lead which provides a direct ground connection from the chip 13. All leads 32, 33, 34 are elevated in the manner of lead 32 as will be explained below.

Figure 3 shows an elevated lead 32 which connects each of the signal leads 14 to the semiconductor chip 13 mounted on the chip support pad 12. The elevated wire lead 33 is bonded at both ends and passes over the ground bus 18 and power bus 22. Thus, the elevated wire leads 32 are disposed roughly parallel to the defined resistors 27.

**Claims**

1. A semiconductor chip carrier of the type comprising a substrate (10) and an array of conductive leads (14, 19, 23) formed on a surface thereof, the leads extending from plural locations at the edges (17) of said substrate (10) toward the center thereof, characterised in that said carrier further comprises a first reference voltage bus (18) formed on the surface of said substrate (10) and substantially surrounding the center of said substrate (10), the conductive leads (14, 19, 23) extending on said surface outwardly of said first reference voltage bus (18) which is connected to one of said conductive leads (19).

2. A semiconductor chip carrier as in claim 1 characterised in that said carrier further comprises a second reference voltage bus (22) formed on the said surface of the substrate substantially surrounding the center of said substrate (10), said second reference bus (22) lying within said first reference voltage bus (18), and said second reference voltage bus (22) being connected to a said conductive lead (23).

3. A semiconductor chip carrier as in claim 2 characterised in that said first and second reference voltage buses (18, 22) are connected to a decoupling capacitor on said substrate (10).

4. A semiconductor chip carrier as in claim 1 characterised in that said first reference voltage bus (18) is at ground potential.

5. A semiconductor chip carrier as in claim 1 characterised in that said carrier further comprises an electrically and thermally conductive pad (12) at the center of said substrate (10) for receiving a semiconductor chip (13) thereon.

6. A seniconductor chip carrier as in claim 1 characterised in that said conductive leads (14, 19, 23) are mostly signal leads (14), said substrate (10) having an elongate zone of selectively removable resistive material (26) bonded thereon between a plurality of said signal leads (14) and said first reference voltage bus (18).

7. A semiconductor chip carrier as in claim 1 characterised in that said leads (14, 19, 23) are copper and have a copper oxide surface adjacent said substrate (10) and fused to said substrate, said substrate being formed from a ceramic material.

**Patentansprüche**

1. Halbleiterchipträger derjenigen Art, die ein Substrat (10) umfaßt, sowie eine auf dessen Oberfläche geformte Anordnung aus leitenden Leitbahnen (14, 19, 23), wobei sich die Leitbahnen von mehreren Stellen an den Rändern (17) des Substrats (10) zu dessen Mitte hin erstrecken, dadurch gekennzeichnet, daß der Träger überdies eine Referenzspannungs-Sammelleitung (18) umfaßt, die auf Oberfläche des Substrats (10) geformt ist und die Mitte des Substrats (10) im wesentlichen umgibt, und daß die leitenden Leitbahnen (14, 19, 23) sich auf der Oberfläche auswärts der ersten Referenzspannungsleitung (18) erstrecken, die mit einer leitenden Leitbahnen (19) verbunden ist.

2. Halbleiterchipträger nach Anspruch 1, dadurch gekennzeichnet, daß der Träger überdies eine zweite Referenzspannungs-Sammelleitung (22) umfaßt die auf der Oberfläche des Substrats geformt ist und die Mitte des Substrats (10) im wesentlichen umgibt, daß die zweite Referenzsammelleitung (22) innerhalb der ersten Referenzspannungs-Sammelleitung (18) liegt, und daß die zweite Referenzspannungs-Sammelleitung (22) mit einer der leitenden Leitbahnen (23) verbunden ist.

3. Halbleiterchipträger nach Anspruch 2, dadurch gekennzeichnet, daß die erste und zweite Referenzspannungs-Sammelleitung (18, 22) mit einem Entkopplungskondensator auf dem Substrat (10) verbunden sind.

4. Halbleiterchipträger nach Anspruch 1, dadurch gekennzeichnet, daß die erste Referenzspannungs-Sammelleitung (18) auf Massepotential liegt.

5. Halbleiterchipträger nach Anspruch 1, dadurch gekennzeichnet, daß der Träger ferner ein elektrisch und thermisch leitendes Polster (12) zur Aufnahme eines Halbleiterchips (13) in der Mitte des Substrats (10) umfaßt.

6. Halbleiterchipträger nach Anspruch 1, dadurch gekennzeichnet, daß die leitenden Leitbahnen (14, 19, 23) hauptsächlich Signalleitungen (14) sind, daß das Substrat (10) eine langgestreckte Zone aus selektiv entfernbarem Widerstandsmaterial (26) aufweist, das haftend mit ihm verbunden ist, und zwar zwischen einer Vielzahl der Signalleitungen (14) und der ersten Referenzspannungs-Sammelleitung (18).

7. Halbleiterchipträger nach Anspruch 1, dadurch gekennzeichnet, daß die Leitungen (14, 19, 23) aus Kupfer bestehen und eine Kupferoxydoberfläche angrenzend an das Substrat (10) aufweisen und mit dem Substrat verschmolzen sind, und daß das Substrat aus einem Keramikmaterial geformt ist.

**Revendications**

1. Un support de puce de semiconducteur du type comprenant un substrat (10) et un réseau de conducteurs (14, 19, 23) formé sur une surface de ce substrat, les conducteurs s'étendant vers le centre du substrat (10) à partir de plusieurs emplacements situés sur les bords (17) du substrat, caractérisé en ce que ce support comprend en outre un premier bus de tension de référence (18) formé sur la surface du substrat (10) et entourant pratiquement le centre du substrat (10), et les conducteurs (14, 19, 23) s'étendent sur cette surface, du côté extérieur du premier bus de tension de référence (18) qui est connecté à l'un des conducteurs (19).

2. Un support de puce de semiconducteur selon la revendication 1, caractérisé en ce que ce support comprend en outre un second bus de tension de référence (22) formé sur ladite surface du substrat et entourant pratiquement le centre du substrat (10), ce second bus de tension de réfe-1rence (22) s'étend à l'intérieur du premier bus de tension de référence (18), et ce second bus de tension de référence (22) est connecté à l'un des conducteurs (23).

3. Un support de puce de semiconducteur selon la revendication 2, caractérisé en ce que les premier et second bus de tension de référence (18, 22) sont connectés à un condensateur de découplage sur le substrat (10).

4. Un support de puce de semiconducteur selon la revendication 1, caractérisé en ce que le premier bus de tension de référence (18) est au potentiel de la masse.

5. Un support de puce de semiconducteur selon la revendication 1, caractérisé en ce que ce support comprend en outre un plot (12) conducteur de l'électricité et de la chaleur, situé au centre du substrat (10) et destiné à recevoir sur sa surface supérieure une puce de semiconducteur (13).

6. Un support de puce de semiconducteur selon la revendication 1, caractérisé en ce que les conducteurs (14, 19, 23) sont en majeure partie des conducteurs de signal (14), et le substrat (10) comporte une zone allongée de matière résistive (26) pouvant être enlevée sélectivement, qui est fixée sur le substrat entre un ensemble de conducteurs de signal (14) et le premier bus de tension de référence (18).

7. Un support de puce de semiconducteur selon la revendication 1, caractérisé en ce que les conducteurs (14, 19, 23) sont en cuivre et comportent une surface en oxyde de cuivre adjacente au substrat (10) et qu'on a fait fusionner avec le substrat, ce substrat étant formé en céramique.

Fig. 1

$Fig. 2$

$Fig. 3$